# EUROPEAN PATENT SPECIFICATION

(11) **EP 0 583 032 B1**
(45) Date of publication and mention of the grant of the patent: **21.01.1998**
(21) Application number: 93202300.5
(22) Date of filing: 04.08.1993
(51) Int. Cl.: G03F 7/30

(54) **Photographic development apparatus**
Photographisches Entwicklungsgerät
Appareil de développement photographique

(30) Priority: 11.08.1992 EP 92202462
(43) Date of publication of application: 16.02.1994
(73) Proprietor: AGFA-GEVAERT N.V., 2640 Mortsel (BE)
(72) Inventor: Verlinden, Bart, B-2640 Mortsel (BE); Claes, Jan, B-2640 Mortsel (BE); Scheerders, Marc, B-2640 Mortsel (BE)

(56) References cited:
- PATENT ABSTRACTS OF JAPAN vol. 16 no. 463 (P-1428) ,25 September 1992 & JP-A-41 066935 (FUJI PHOTO FILM CO LTD) 12 June 1992,
- PATENT ABSTRACTS OF JAPAN vol. 15 no. 305 (P-1234) ,5 August 1991 & JP-A-03 107167 (FUJI PHOTO FILM CO LTD) 7 May 1991,
- PATENT ABSTRACTS OF JAPAN vol. 10 no. 312 (P-509) [2368] ,23 October 1986 & JP-A-61 123846 (KONISHIROKU PHOTO INDUSTRY CO., LTD.,) 11 June 1986,

## Description

### Background of Invention

### Field of Invention

This invention relates to apparatus for the development of exposed photographic material, and in particular to apparatus for developing lithographic offset printing plates.

### Description of the Prior Art

In an apparatus or system for the development of aluminium lithographic printing plates of the type disclosed in EP-A-410500 it is advantageous to maintain the strength of the processing liquids within specified limits so as to maintain high quality printing plates, and reduce waste products.

This can be achieved by constantly topping up a process liquid reservoir or bath by automatic means as photographic material is processed.

The exhaustion of the chemicals in the baths can normally be directly correlated with the amount of processed material passing through the apparatus. This in turn is directly related to the surface area of the material being processed.

A known surface area detection means comprises one sensor for sensing the length of processed material, and an array of sensors to determine the width of the material. Such a system is relatively expensive since to measure random material widths with precision requires a large number of sensors. For example, offset printing plates may vary in width from 225 mm to 800 mm and if it is necessary to measure all possible combinations of standard material widths from 200 mm upwards within a 10% accuracy band some 30 sensors are necessary, and within a 20% accuracy band some 16 sensors are necessary.

Another known surface area detection means is disclosed in JP-A-4 166 935 (Fuji Photo Film Co. Ltd.). This system likewise comprises one sensor for sensing the length of processed material. The width size of the material is determined on the basis of a previously set ratio length to width in the processing direction of the photosensitive material. It is clear that this system will work satisfactorily only if all the different sheet formats being processed have (nearly) the same ratio of length to width, and if all the sheets are being processed lengthwise. On the contrary, if a sheet is being processed widthwise, the length sensor will errorneously consider a smaller dimension, in accordance with the set ratio, as being the width belonging to the measured "length". Alos, the use of the ratio length to width for the control of the replenishment forms a serious limitation of the number of sheet formats that can be used in the apparatus.

### Summary of Invention

### Object of Invention

The present invention provides a simple means of calculating the surface area of the processed material which is suitable for a selection of sheets of multiple formats and which operates independently from whether the sheet is transported lengthwise or widthwise through a processor.

### Statement of Invention

The above object is achieved with an apparatus according to claim 1. Preferred embodiments of the invention are defined in the dependent claims.

Preferably the apparatus is for the processing of exposed aluminium lithographic offset printing plates. Offset printing plates are never supplied in exact standard A1, A2, A3, etc., formats having a constant ratio of length to width since the plate is always larger than the paper format in the length direction to enable the plate to be secured around a printing drum. However, in the event that the sensor measures a dimension which is exactly the same as a stored dimension given in two or more format sizes, then the comparator means produces a signal indicative of the largest sheet format containing said dimension.

Preferably the apparatus includes a sheet feed means, and a feed sensor which senses when the sheet is substantially centralised relative to the sheet feed means, the feed sensor being operable to prevent the operation of the feed sheet means if the presence of a sheet is not sensed.

In a further preferred embodiment, the apparatus includes a sheet feed means that is driven through a clutch means, the clutch means being controlled by at least one further sensor which senses a process parameter so that the feed means is operable only when a desired value of process parameter is reached.

### Brief Description of Drawings

The invention will be described by way of example and with reference to the accompanying drawings in which :
fig. 1 is a schematic layout of one embodiment of a processing apparatus according to the invention, and
fig. 2 is a plan view of a sheet of material which is processed by the apparatus.

### Detailed Description of the Invention

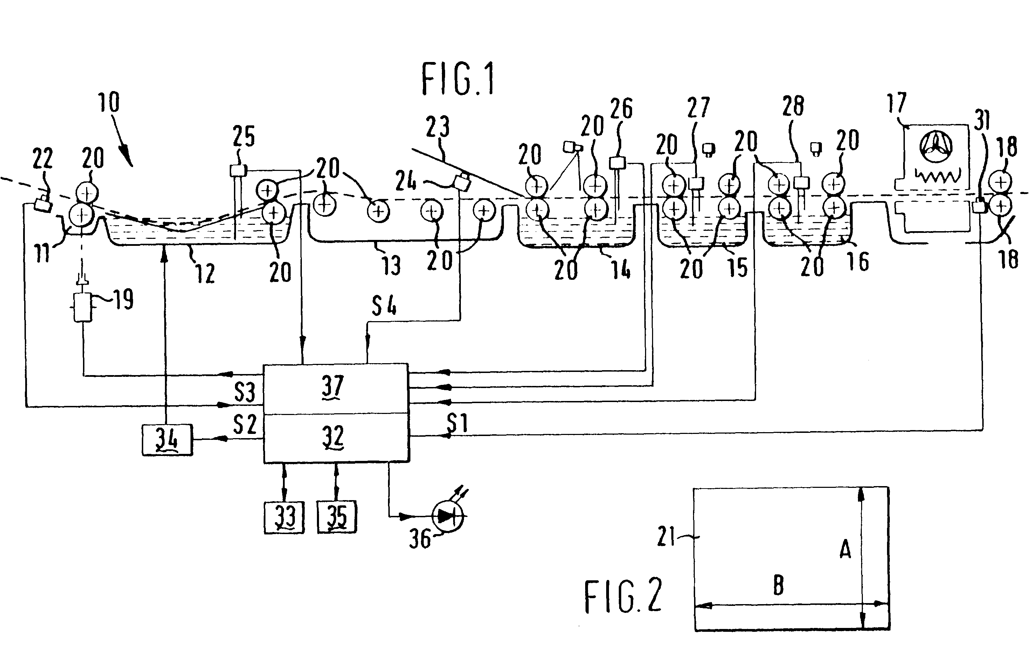

With reference to figure 1 there is illustrated a longitudinal cross-section through an apparatus 10 for processing exposed photographic sheet material, in particular aluminium lithographic printing plates, of the type described in EP-A-410500.

EP-A-410500 discloses an imaging element containing an aluminium support provided with in the order given an image receiving layer and a photosensitive layer containing a silver halide emulsion. In the document there is disclosed a diffusion transfer reversal process (hereinafter called DTR-process) for obtaining a lithographic printing plate in which said imaging element is image-wise exposed and subsequently developed using a developing liquid or activating liquid in the presence of a silver halide complexing agent. The imaging element is then guided through a diffusion transfer zone so that the silver halide complexes formed during the development step are allowed to diffuse into the image-receiving layer where they are converted to silver. When the imaging element leaves the diffusion transfer zone a silver image is formed in the image receiving layer. The now useless photosensitive layer and optional other layers above the image receiving layer are then removed by rinsing the imaging element in a washing section. Finally the element now carrying a silver image on its surface is treated with a finishing liquid that contains so called hydrophobizing agent for improving the hydrophobicity of the silver image.

In the above described method for obtaining an aluminium based lithographic printing plate according to the DTR-process generally three different liquids are used i.e. a developing or activating liquid, a rinsing liquid and a finishing liquid.

The apparatus 10 is mounted within a generally rectangular housing which may include a rectangular metal frame (not shown) for supporting the various parts of the apparatus.

The apparatus comprises a sheet feed means 11, preferably a pair of rollers 20, a developing section 12, a diffusion transfer section 13, a wash section 14, a rinse section 15, a finishing section 16, a drier 17, and output rollers 18. All these sections are linked by a single drive screw so that all the sections' rollers 20 can operate simultaneously at the same speed.

Now in use the developing liquid, rinsing liquid and finishing liquid may be automatically replenished, however, for simplicity the present apparatus will only be described with reference to the replenishment of the developing liquid or activating liquid in the developing section.

A typical aluminium sheet or plate 21 is shown in figure 2, and has basically a width A and a length B. These sizes A & B are loosely based on standard A1, A2, A3, etc., formats and will have maximum dimensions of about 80 cms width A, and 1.10 metre length B. As the plate 21 passes through the apparatus 10, the consumption of the chemicals in the various sections 12, 15, 16, directly relates to the area of the plate. The image on the plate generally involves about 10% - 25% of the area of the plate and therefore the correlation between chemical consumption and area of the plate 21 passing through the apparatus is good.

In order to measure the area of sheet material passing through the apparatus, a length sensor 31 is preferably arranged at a position where the velocity of the processed sheet through the apparatus is constant. A suitable position is at the output end of the apparatus between the drier 17 and the output rollers 18.

The sensor 31 can be an optical sensor, a mechanical sensor, or any other suitable device which can determine the length of a passing sheet material.

A signal S1 from the sensor 31 passes to a first controller 32 which can calculate the length of the sheet material from the process speed and the detection time, (i.e. the time the sensor 31 is operating).

The controller 32 compares the dimension measured with preprogrammed dimensions for various formats of sheet material held in memory 33. In the event of the controller 32 matching the measured dimension and a stored dimension a signal S2 is sent to a replenishment means 34 where the signal S2 is utilised to provide automatic replenishment of the developing fluid in accordance with the signal S2.

Aluminium printing plates are not exactly A1, A2, A3, etc., standard sizes and it is therefore unlikely that a given dimension will appear more than once in the memory. However in the event that the measured dimension occurs more than once in the memory, the controller 32 can provide a signal S2 corresponding to the largest plate format containing that dimension.

The dimensions of given sheets of material to be processed could be stored directly into the memory 33, during manufacture, but preferably can be entered into the memory by a user operable unit means 35 such as a key board, or a bar code reader.

In the event that measured length does not correspond with a pre-programmed dimension the system gives an error signal through an alarm 36 such as a light emitting diode, and sends a signal S2 corresponding to a previous counted surface area of a plate format with a length dimension longer than the detected one, or sends a signal S2 corresponding to a surface are equal to the length measured multiplied by the maximum plate width.

In order to achieve optimum processing conditions through the machine, any plates 21 should be roughly centralised with respect to the longitudinal centre line of the apparatus.

The following table gives a survey of different plate sizes that were used in an apparatus according to the present invention for covering standard A3, A2 and A1 formats. The differences in plate sizes are explained by differences in the drum mechanisms of the printing presses, by the use of the printed sheets : cutting, folding, etc.

| | | | |
|---|---|---|---|
| Format | A3 | Plate sizes | 510 x 400 |
| | | | 450 x 370 |
| | | | 462 x 458 |
| | | | 602 x 398 |
| | A2 | | 650 x 550 |
| | | | 660 x 510 |
| | | | 730 x 605 |
| | | | 724 x 615 |
| | | | 650 x 530 |
| | | | 620 x 457 |
| | | | 889 x 586 |
| | A1 | | 1030 x 770 |
| | | | 1020 x 820 |
| | | | 1030 x 790 |
| | | | 1045 x 795 |
| | | | 1085 x 745 |
| | | | 915 x 715 |

The plates 21 are fed into the apparatus 10 through a pair of rollers 11 which are driven by a clutch means 19. The clutch means 19 could be a mechanical clutch but is preferably an electromagnetic clutch operated by a clutch control means 37.

The clutch control means 37 is connected to a feed sensor 22 which is located on the longitudinal centre line of the apparatus. The control means 37 operates to control the clutch for rotation of the feed rollers 11 only when the sensor 22 detects that the plate 21 is being fed roughly centrally into the apparatus and sends a signal S3 to the control 37. More positive guide means may also by necessary to centralise the plate.

The clutch controller 37 may be programmed to operate a time delay after initial detection of a plate to allow for precise positioning of a plate 21 against static rollers 11.

The apparatus 10 may include a rewash facility 23 for feeding already processed and reworked plates back into the wash section 14. A second feed sensor 24 is located on the rewash facility to sense the presence of plates thereon. A signal S4 will be sent to the clutch control 37 which will prevent the operation of the clutch means 19 thereby preventing the input of plates until the rewashed plate is processed.

The process conditions within the developing section 12, wash section 14, rinse section 15, and finishing section 16 can be monitored by condition sensors 25, 26, 27, and 28 respectively.

In the event that the sensed conditions do not fall within predetermed process parameters the clutch control will prevent operation of the input rollers. In the event that the process conditions return to required value, then the input of the machine will be restored automatically.

The invention is not limited to the embodiment disclosed hereinbefore. The apparatus according to the invention can be used for processing photographic materials other than aluminium lithograhic printing plates, such as printing plates with a polyethylene terephthalate support, and other conventional photographic materials requiring careful control of the replenishment of their processing baths.

The use of the apparatus is not limited to the range of formats mentioned, and the length sensor 31 can be located at other suitable positions on the apparatus where the process velocity is constant e.g. the diffusion section.

## Claims

1. Apparatus (10) for the development of exposed photographic sheet material (21), said apparatus including a sensor (31) for determining one linear dimension of the material and a device (32, 33) for the calculation of the surface area of rectangular photographic sheet material processed in response to such one dimension, characterized in that said device comprises memory means (33) for storing information relating to the width as well as length dimensions of given formats of rectangular sheets of material to be processed in the apparatus, and control means (32) for comparing the measured dimension with said stored dimensions and producing a signal (S2) indicative of a surface area when there is a match between a stored dimension and measured dimension and if said sensor (31) measures a dimension which is substantially the same as a dimension given in more than one format size, for producing a signal indicative of the largest sheet format containing said dimension.

2. Apparatus as claimed in claim 1 of claim 2, wherein in the event of there being no match between a stored and a measured dimension, the control means multiplies the measured length by the maximum stored width to give said signal.

3. Apparatus as claimed in claims 1 or 2, wherein in the event of there being no match between a measured and a stored dimension, the control means takes a previously calculated surface area of a plate having a format with a length longer than the measured length.

4. Apparatus as claimed in any one of claims 1 to 3, characterised in that said sensor is arranged at a location on the apparatus where the velocity of processed sheet material through the apparatus is constant.

5. Apparatus as claimed in any one of claims 1 to 4 wherein the apparatus further includes a sheet feed means (11), and a feed sensor (22) which senses when the sheet (21) is substantially centralised relative to the sheet feed means (11), the feed sensor (22) being operable to prevent the operation of the feed sheet means if the presence of a sheet is not sensed.

6. Apparatus as claimed in claim 5, characterised in that said apparatus includes at least one further sensor (24, 25, 26, 27, 28) which senses a process parameter in the apparatus (10) and the feed sheet means (11) is driven through a clutch means (19) which is inoperable if the sensed process parameter has not reached a desired state.

7. Apparatus as claimed in any one of claims 1 to 6 for the development of aluminium lithographic offset printing plates.

## Patentansprüche

1. Ein Gerät (10) zur Entwicklung von belichtetem fotografischem Bogenmaterial (21), wobei das Gerät einen die Länge des Materials ermittelnden Sensor (31) und ein Element (32, 33) zur Berechnung des Oberflächeninhalts von entsprechend der ermittelten Länge verarbeitetem rechteckigem fotografischem Bogenmaterial umfaßt, dadurch gekennzeichnet, daß das Gerät ein Speicherelement (33), das Information bezüglich der Breite und Länge von vorgegebenen Formaten von rechteckigen, im Gerät zu verarbeitenden Materialbogen speichert, und ein Steuerelement (32) umfaßt, das die gemessene Abmessung mit den gespeicherten Abmessungen vergleicht und ein einen Oberflächeninhalt darstellendes Signal (S2) erstellt, wenn es Übereinstimmung zwischen einer gespeicherten Abmessung und einer gemessenen Abmessung gibt und wenn Sensor (31) eine Abmessung mißt, die wesentlich dieselbe ist als eine in mehr als einer Formatgröße bestehende Abmessung, um ein das größtmögliche, die Abmessung umfassende Bogenformat darstellendes Signal zu erstellen.

2. Gerät nach Anspruch 1, dadurch gekennzeichnet, daß falls es keine Übereinstimmung zwischen einer gespeicherten Abmessung und einer gemessenen Abmessung besteht, das Steuerelement die gemessene Länge mit der gespeicherten Höchstbreite multipliziert, um das Signal zu verschaffen.

3. Gerät nach Anspruch 1 oder 2, dadurch gekennzeichnet, daß falls es keine Übereinstimmung zwischen einer gemessenen Abmessung und einer gespeicherten Abmessung besteht, das Steuerelement einen vorigen berechneten Oberflächeninhalt einer Platte mit einem Format, bei dem die Länge größer ist als die gemessene Länge, als Ausgangswert nimmt.

4. Gerät nach irgendeinem der Ansprüche 1 bis 3, dadurch gekennzeichnet, daß der Sensor an einer Stelle auf dem Gerät, an der die Geschwindigkeit des verarbeiteten, durch das Gerät . beförderten Bogens konstant ist, angeordnet ist.

5. Gerät nach irgendeinem der Ansprüche 1 bis 4, dadurch gekennzeichnet, daß das Gerät weiterhin ein Bogenzufuhrelement (11) und einen Zufuhrsensor (22) umfaßt, der nachweist, wenn sich der Bogen (21) wesentlich in der Mitte bezogen auf das Bogenzufuhrelement (11) befindet, wobei der Zufuhrsensor (22) das Bogenzufuhrelement ausschaltet, sobald kein Bogen mehr beobachtet wird.

6. Gerät nach Anspruch 5, dadurch gekennzeichnet, daß das Gerät wenigstens einen weiteren, einen Prozeßparameter im Gerät (10) nachweisenden Sensor (24, 25, 26, 27, 28) umfaßt und das Bogenzufuhrelement (11) durch ein Kupplungselement (19), das nur eingeschaltet wird, wenn der nachgewiesene Prozeßparameter einen erwünschten Wert erreicht hat, angetrieben wird.

7. Gerät nach irgendeinem der Ansprüche 1 bis 6 für die Entwicklung von lithografischen Aluminium-Offsetdruckplatten.

## Revendications

1. Appareil (10) pour le développement d'un matériau photographique en feuille exposé (21), ledit appareil englobant un palpeur (31) pour déterminer une dimension linéaire du matériau et un dispositif (32, 33) pour le calcul de l'aire de surface du matériau photographique en feuille rectangulaire traité en réponse à ladite dimension, caractérisé en ce que ledit dispositif comprend un moyen de mémoire (33) pour stocker des informations concernant les dimensions de largeur et de longueur de formats donnés de feuilles rectangulaires de matériaux à traiter dans l'appareil, et un moyen de commande (32) pour comparer la dimension mesurée auxdites dimensions stockées et pour générer un signal (S2) indiquant une aire de surface lorsqu'une correspondance a été établie entre une dimension stockée et la dimension mesurée, et dans le cas où ledit palpeur (31) mesure une dimension qui est essentiellement la même qu'une dimension donnée dans plus d'une dimension de format, pour générer un signal indiquant le format de feuille maximal contenant ladite dimension.

2. Appareil selon la revendication 1, dans lequel, dans le cas où aucune correspondance n'a été établie entre une dimension stockée et la dimension mesurée, le moyen de commande multiplie la longueur mesurée par la largeur stockée maximale pour générer ledit signal.

3. Appareil selon la revendication 1 ou 2, dans lequel, dans le cas où aucune correspondance n'a été établie entre la dimension mesurée et une dimension stockée, le moyen de commande prend une aire de surface calculée au préalable d'un cliché possédant un format dont la longueur est supérieure à la longueur mesurée.

4. Appareil selon l'une quelconque des revendications 1 à 3, caractérisé en ce que ledit palpeur est arrangé à un endroit de l'appareil, auquel la vitesse de passage du matériau en feuille traité à travers l'appareil est constante.

5. Appareil selon l'une quelconque des revendications 1 à 4, dans lequel l'appareil englobe en outre un moyen d'alimentation de feuilles (11) et un palpeur d'alimentation (22) qui détecte le moment où la feuille (21) est essentiellement centrée par rapport au moyen d'alimentation de feuilles (11), le palpeur d'alimentation (22) étant mis en service pour empêcher le fonctionnement du moyen d'alimentation de feuilles lorsque la présence d'une feuille n'a pas été détectée.

6. Appareil selon la revendication 5, caractérisé en ce que ledit appareil englobe au moins un palpeur supplémentaire (24, 25, 26, 27, 28) qui détecte un paramètre opératoire dans l'appareil (10), le moyen d'alimentation de feuilles (11) étant entraîné via un moyen d'embrayage (19) qui ne peut être mis en service tant que le paramètre opératoire détecté n'a pas atteint un état désiré.

7. Appareil selon l'une quelconque des revendications 1 à 6, pour le développement de clichés lithographiques offset en aluminium.
